# EUROPEAN PATENT APPLICATION

(11) **EP 2 696 363 A1**
(43) Date of publication of application: **12.02.2014**
(21) Application number: 12764716.2
(22) Date of filing: 29.02.2012
(51) Int. Cl.: H01J 37/244, H01J 37/16, H01J 37/26

(54) **ELECTRON MICROSCOPE**

(30) Priority: 31.03.2011 JP 2011077103
(71) Applicant: Hitachi High-Technologies Corporation, Tokyo 105-8717 (JP)
(72) Inventor: NODA, Hiroyuki, Chiyoda-ku, Tokyo 100-8280 (JP); ONUMA, Mitsuru, Chiyoda-ku, Tokyo 100-8280 (JP); NAGAOKI, Isao, Hitachinaka-shi, Ibaraki 312-8504 (JP); MAMISHIN, Shuichi, Minato-ku, Tokyo (JP)
(74) Representative: MERH-IP Matias Erny Reichl Hoffmann
(86) International application number: PCT/JP2012/001363
(87) International publication number: WO 2012/132230

(57) **Abstract**

This electron microscope (20) comprises: a first imaging device (291); a second imaging device (240)that can be moved away from transmitted light (P); and another detection device (260). The second imaging device is disposed in an observation chamber (230) above the first imaging device, and an attachment portion (231) of the other detection device is disposed at a position rotated 90 degrees from the attachment position of the second imaging device on the same plane on which the second imaging device is disposed. Thus, the second imaging means and the other detector can be attached compactly to the observation chamber disposed on the table surface of a mount housing, whereby an electron microscope can be provided in which workability of the devices and effective use of the table surface are achieved.

## Description

### TECHNICAL FIELD

The present invention relates to an electron microscope having an observation chamber below an electron optical column portion and a second imaging device mounted in this observation chamber.

### BACKGROUND ART

An electron microscope is an electron microscope of a type which directs an electron beam at a sample to be observed, magnifies an interference figure created either by electrons transmitted through the sample or by reflected electrons, and observes the interference figure. Electron microscopes have enjoyed widespread usage in physics, chemistry, engineering, biology, medicine, and other applications.

It is known that electron microscopes are classified into two major types: a transmission electron microscope (TEM) which directs an electron beam at a sample to be observed, magnifies electrons transmitted through the sample, and observes them and a scanning electron microscope (SEM) which directs an electron beam at a sample to be observed and observes an image derived from electrons (or secondary electrons) reflected from the sample. In recent years, scanning transmission electron microscopes (STEM) having the features of the above-described two types have attracted attention. Each of these electron microscopes is so configured that the body portion of the electron microscope is constituted by an electron optical column portion and a pedestal housing supporting it. The microscope body portion is controlled with a monitor device. Images acquired by the electron microscope body portion are checked on the display device of the monitor device.

For example, a transmission electron microscope has structures for directing an electron beam generated at a higher portion of the electron optical column portion at a sample within the optical column portion, projecting the transmitted beam onto a first fluorescent screen mounted in a lower end portion of the optical column portion, imaging the projected subject with a first imaging means (such as a CCD camera), and checking or recording the imaged subject with the display device of the monitor device.

In these prior art examples, an observation chamber is mounted above the first fluorescent screen. This observation chamber is equipped with a structure in which either a scintillator permitting observation with a second imaging device (such as a CCD camera) or other detecting device for obtaining a dark field image or a bright field image can be mounted. The scintillator or other detecting device is so configured that it can be retracted relative to an electron beam directed at the first fluorescent screen such that acquisition of images by the first imaging device is not hindered.

### CITATION LIST

### PATENT LITERATURE

Patent Literature 1: JP-A-9-82263
Patent Literature 2: JP-A-9-223478
Patent Literature 3: JP-A-2003-331773

### SUMMARY OF INVENTION

### TECHNICAL PROBLEM

In the transmission electron microscope of the above-described prior art example, a lower end portion of the electron optical column portion in which the first fluorescent screen and the first imaging device are mounted is attached in the pedestal housing. The electron optical column portion is mounted to the pedestal housing such that an observation chamber formed over the first fluorescent screen is exposed from a table surface that covers the top surface of the pedestal housing. The scintillator or other detecting device mounted in this observation chamber is mounted so as to be retractable relative to a horizontal direction perpendicular to the beam axis of a vertical electron beam.

For example, the scintillator is configured including a second fluorescent screen, a mirror for refracting the beam, which has been transmitted through the second fluorescent screen, in the horizontal direction, a second imaging means for imaging the beam reflected off the mirror, and a drive mechanism for retracting the second fluorescent screen, mirror, and so on. Furthermore, in another prior art example proposed, a second fluorescent screen which is made to protrude on the beam axis in an oblique posture by rotating the screen from its retracted posture is mounted in the observation chamber. An image projected onto the second fluorescent screen is imaged by the second imaging means.

In this way, in the prior art transmission electron microscope, the scintillator occupies a large space in the observation chamber and so, in order to mount other detecting device, the device has had to be mounted in a position below the table surface so as to avoid the range of operation of the scintillator. However, workability in positions below the table surface is low and, therefore, the maintainability presents problems.

Furthermore, since the electron beam directed downward from above the observation chamber is directed radially toward the first fluorescent screen, other detecting device mounted so as to be retractable from a lateral direction of the beam axis of the electron beam cannot be retracted unless moved more in going downward along the observation chamber. That is, imaging of the first fluorescent screen will be hindered unless the other detecting device is moved greatly in a horizontal direction. Therefore, the other detecting device including the drive mechanism has been increased in size.

Accordingly, it is an object of this invention is to provide an electron microscope which can provide good workability of second imaging means and other detecting device and make effective use of a table surface by compactly mounting these devices in an observation chamber mounted over the table surface of a pedestal housing.

### SOLUTION TO PROBLEM

To achieve the above-described object, an electron microscope associated with the present invention has a second imaging device mounted in an observation chamber, the second imaging device being mounted so as to be retractable relative to a transmitted beam. A mounting portion for other detecting device is mounted at a position in flush with the position at which the second imaging device is mounted.

### ADVANTAGEOUS EFFECTS OF INVENTION

In the present invention, the second imaging device and other detecting device or devices can be mounted within the same plane in the observation chamber and so good workability of these devices can be provided and effective use of the table surface can be made by compactly mounting the second imaging means and other detecting device (including a side camera) in the observation chamber mounted over the table surface of the pedestal housing.

### BRIEF DESCRIPTION OF DRAWINGS

FIG. 1 is a schematic structural diagram of an electron microscope system associated with embodiment 1.
FIG. 2 is an instrumental structural diagram of the electron microscope system associated with embodiment 1.
FIG. 3 is a cross-sectional view of vicinities of the observation chamber of the electron microscope system associated with embodiment 1.
FIG. 4 is an appearance diagram of a shield cover for other detecting device of the electron microscope system associated with embodiment 1.
FIG. 5 is a structural diagram of vicinities of the observation chamber of an electron microscope system associated with embodiment 2.
FIG. 6 is a structural diagram of vicinities of the observation chamber of the electron microscope system associated with embodiment 2.

### DESCRIPTION OF EMBODIMENTS

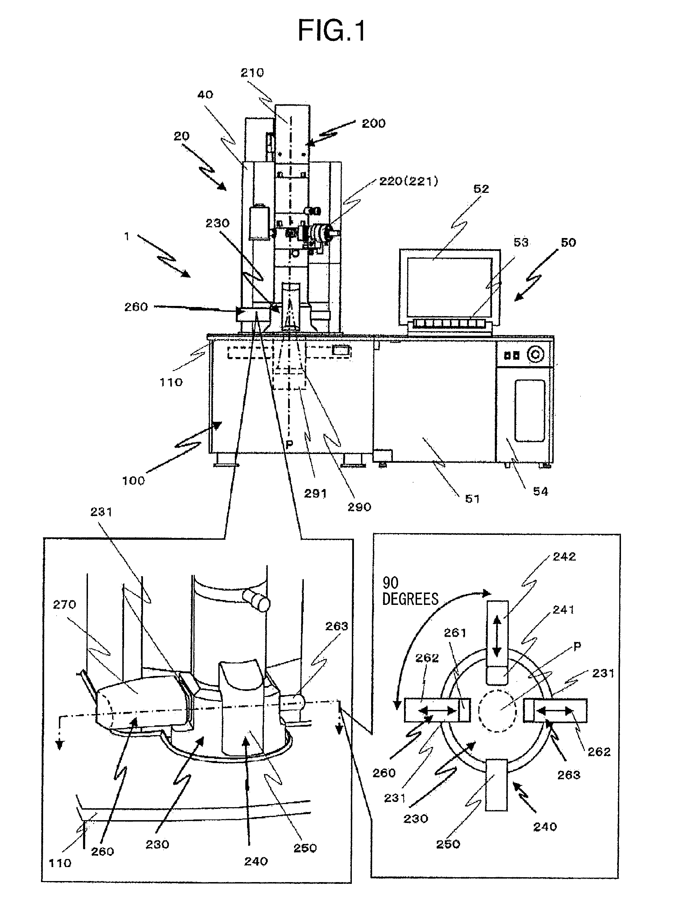

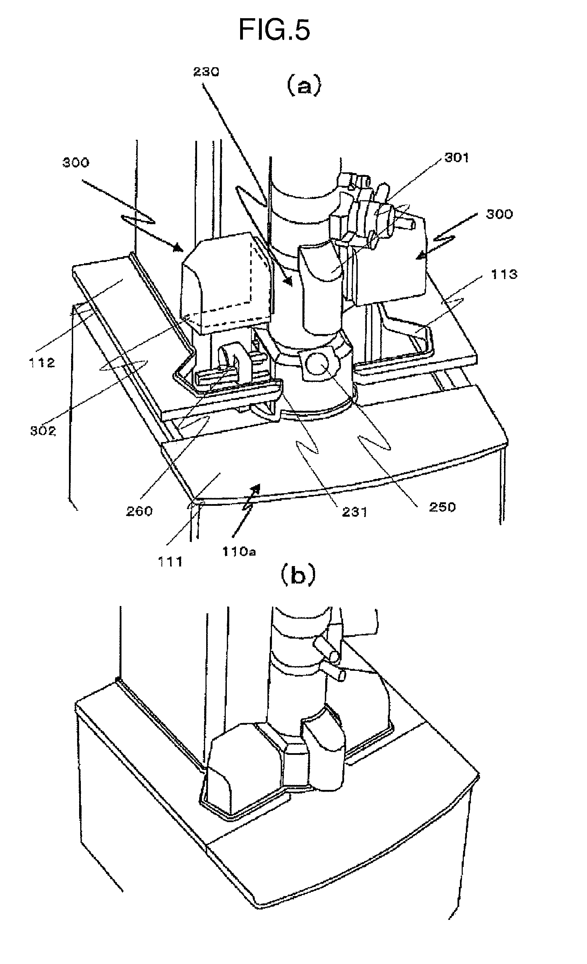

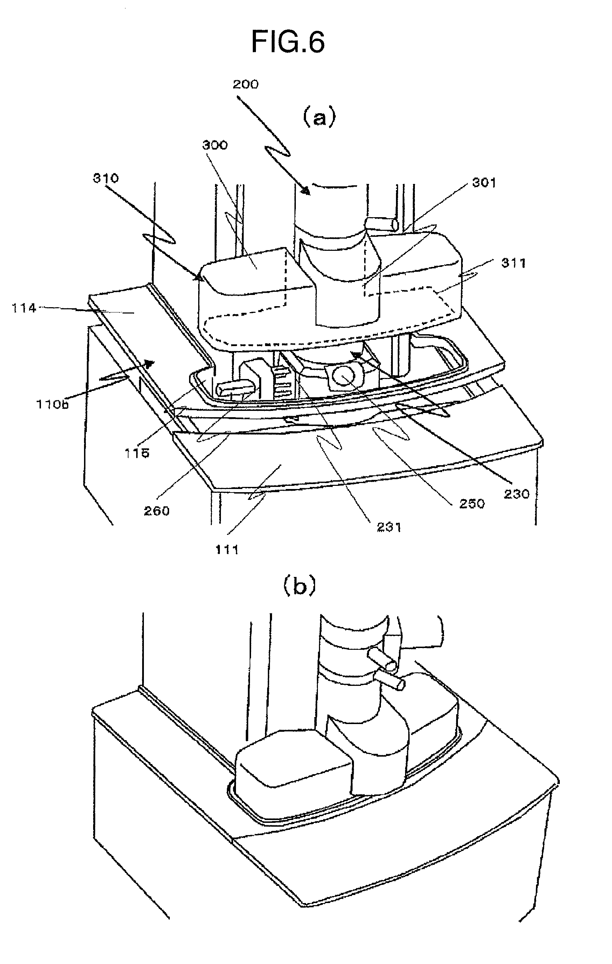

Embodiments of an electron microscope system associated with this invention are hereinafter described specifically with reference to FIGS. 1 to 6. FIGS. 1-4 indicate embodiment 1. FIGS. 5 and 6 indicate other embodiment of a detector cover. Similar parts, arrows, and so on are indicated by the same reference numerals and a repetition of the description thereof is omitted.

### EMBODIMENT 1

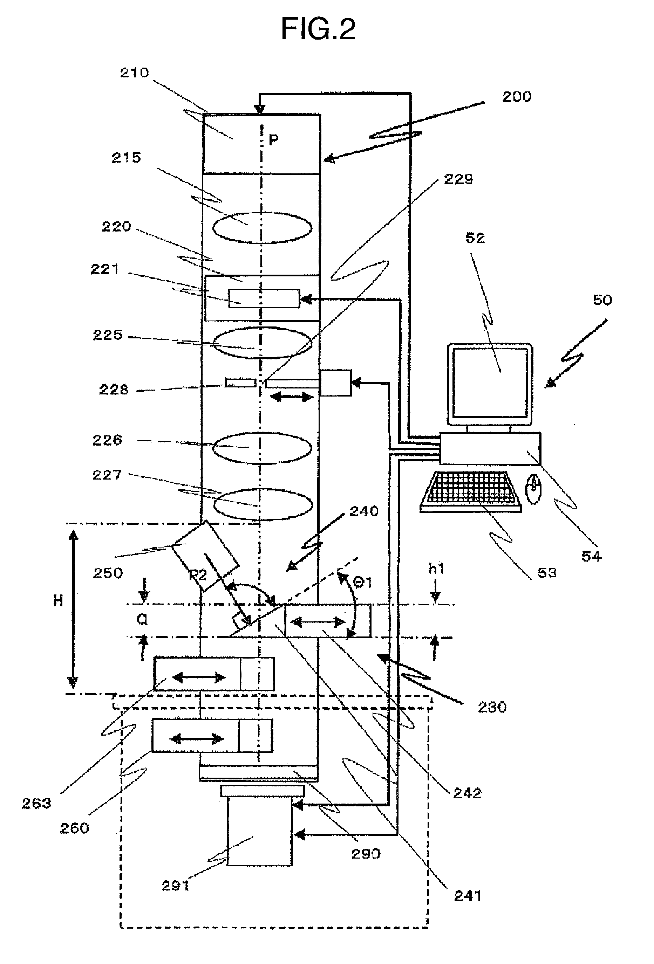

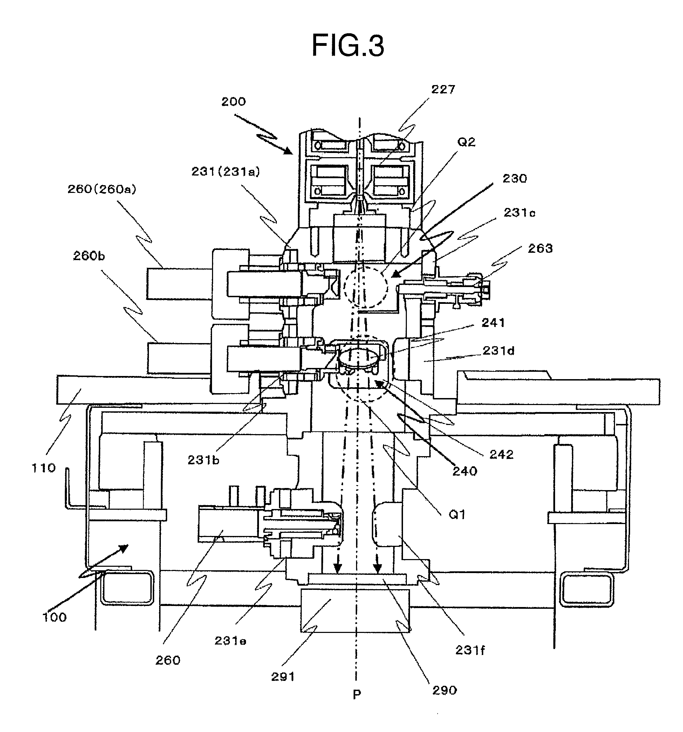

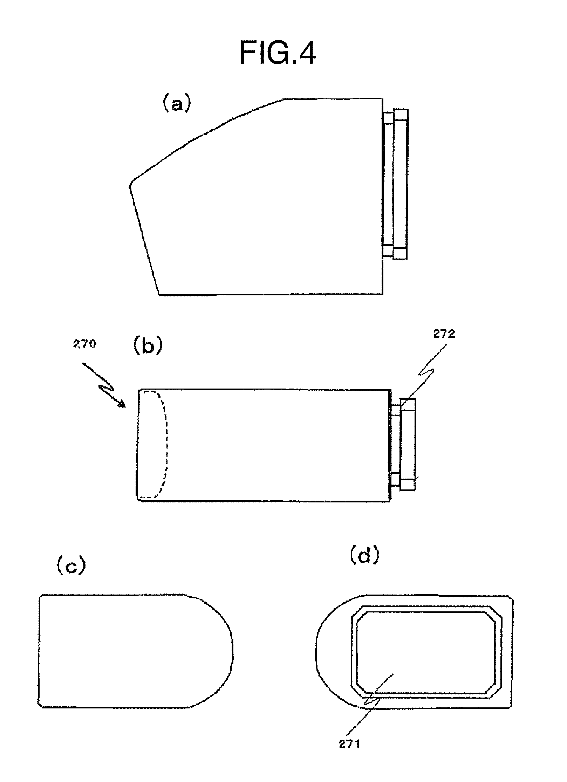

An electron microscope system associated with embodiment 1 is described in detail with reference to FIGS. 1 to 4. FIG. 1 is a schematic structural diagram of an electron microscope system associated with this embodiment. FIG. 2 is an instrumental structural diagram of the electron microscope system associated with this embodiment. FIG. 3 is a cross-sectional view of vicinities of the observation chamber of the electron microscope system associated with this embodiment. FIG. 4 is an appearance diagram of a shield cover for other detecting device of the electron microscope system associated with this embodiment.

A schematic structural diagram of an electron microscope system associated with this embodiment is first described by referring to FIG. 1. In FIG. 1, the electron microscope system, generally indicated by symbol 1, is configured including a transmission electron microscope body 20 for observing a sample 221 to be observed by directing an electron beam at the sample and magnifying and observing electrons transmitted through the sample and a monitor device 50 for monitoring an acquired magnified image by manipulating and controlling the electron microscope body 20. The electron microscope body 20 is configured including an electron optical column portion 200 supported on a pedestal housing 100 and a peripheral device housing 40 incorporating vacuum equipment.

The electron microscope body 20 associated with this embodiment can make an electron beam generated by an electron gun 210 disposed at the highest portion of the electron optical column portion 200 including electron optics therein transmit through the sample 221 to be observed and set in a sample insertion portion 220 disposed in a middle stage of the electron optical column portion 200, focus an image of the transmitted electron beam onto a first fluorescent screen portion 290 disposed below the electron optical column portion 200, pick up the focused image with a first camera portion 291 constituting first imaging means and disposed below the first fluorescent screen portion 290, and monitor the image with the monitor device 50.

Also, in this embodiment, a table surface 110 sits over the pedestal housing 100. A lower end portion of the electron optical column portion 200 is mounted to the pedestal housing 100 such that an observation chamber 230 formed over the fluorescent screen 290 is exposed from the table surface 110. This observation chamber 230 has a second imaging device 240 equipped with a second camera portion 250 constituting second imaging means for directly observing the image transmitted through the sample 221. Other detecting device 260 can be detachably mounted in the observation chamber 230. One example of the other detecting device 260 is a dark field detector for obtaining a dark field image. Another example is a bright field detector for obtaining a bright field image. The other detecting device is not restricted to these examples.

The monitor device 50 is configured including a table housing 51 capable of being disposed with good compatibility with the table surface 110 of the pedestal housing 100, a display portion 52 for displaying various images and an observed image, input devices 53 such a keyboard and a mouse, and a control unit 54 providing overall control of the electron microscope system 1. This monitor device 50 has the instrumental configuration of a general personal computer and can include a storage device (not shown) storing image information and various programs and a communication device for connection with other computer systems. This monitor device 50 permits the electron microscope body 20 to be manipulated and controlled smoothly. Also, a magnified image acquired by this electron microscope body 20 can be observed and analyzed or sent to other system via a network.

One great feature of the electron microscope body 20 associated with this embodiment is that the other detecting device 260 located at a position lying in the same plane as the second imaging device 240 can be mounted. The second imaging device 240 is mounted in the observation chamber 230 such that the device 240 can be retracted relative to the beam axis (optical axis) P of the electron beam.

Preferably, the other detector 260 can be mounted at a position obtained by rotating the position of the second imaging device 240 in a horizontal direction through 90 degrees. The other detector 260 includes a side camera.

That is, as shown in the right call-out of FIG. 1, in this embodiment, the second imaging device 240 is configured including a second fluorescent screen 241 mounted so as to be retractable relative to the beam axis P of the electron beam via a horizontal drive device 242 and the second camera portion 250 disposed on a side surface of the observation chamber 230. The second camera portion 250 and the horizontal drive device 242 are mounted to side surfaces of the observation chamber 230 on the opposite sides (before and after) the optical axis P of the electron beam. The second fluorescent screen 241 disposed on the beam axis P of the electron beam is retracted rearward by operating the horizontal drive device 242.

The observation chamber 230 of this embodiment has a detector mounting portion 231 for detachably mounting the other detecting device 260 to left and right side surfaces which are obtained by rotating the positions of the second camera portion 250 and the horizontal drive device 242 through 90 degrees. The other detecting device 260 mounted to this detector mounting portion 231 is configured including other detector 261 for obtaining a dark field image or a bright field image and a horizontal drive device 262 for horizontally retracting the other detector 261 relative to the beam axis P of the electron beam.

An electron beam stopper 263 having the horizontal drive device 262 for horizontally retracting the other detector 261 relative to the beam axis P of the electron beam similarly to the other detector 261 can be mounted to the detector mounting portion 231 of this embodiment. In the instance of FIG. 1, it is shown that the other detecting device 260 is mounted on the left side of the observation chamber 230 and that the electron beam stopper 263 is mounted on the right side.

In this way, in this embodiment, the other detecting device 260 is mounted so as to be attachable at the position rotated through 90 degrees relative to the second imaging device 240. Therefore, the range of operation of the second fluorescent screen 241 of the observation chamber 230 can be made the range of operation of the other detecting device 260. That is, in this embodiment, the height at which the other detecting device 260 is mounted in the observation chamber 230 can be made flush with the height of the second imaging device 240. Accordingly, the other detecting device 260 which could have been conventionally mounted only below the table surface 110 can be mounted over the table surface 110, where easy maintenance is achieved. Although there is the problem that data obtained by the other detecting device 260 such as a side camera are data obtained by a 90-degree rotation, it is easy to make a 90-degree rotation in converting image data by an image processing portion (not shown). Hence, this problem can be solved easily. Obviously, an image can be obtained by image processing by the image processing portion in whatever position it is placed within the same plane.

Furthermore, in this embodiment, the height at which the other detecting device 260 is mounted can be brought to a position lying above the observation chamber 230 from a position lying below the observation chamber 230 close to the first fluorescent screen portion 290. Therefore, the other detecting device 260 can be made smaller in size.

That is, the electron beam transmitted through the sample 221 is emitted radially from above the observation chamber 230 and focused onto the first fluorescent screen portion 290 as indicated by the broken line in FIG. 1. Therefore, where evacuated away from the electron beam emitted radially, it is necessary to increase the amount of movement made by the retracting other detecting device 260 in approaching the first fluorescent screen portion 290. That is, as the other detecting device 260 is mounted at a position closer to the first fluorescent screen portion 290, the horizontal drive device 262 needs to be made larger in size. In this respect, in this embodiment, the other detecting device 260 can be mounted above the observation chamber 230 and so the horizontal drive device 262 can be made smaller in size.

Furthermore, in this embodiment, the second camera portion 250 is fixedly mounted to a front portion of the observation chamber 230. In addition, a CCD camera having a compact structure is adopted. Therefore, the amount of forward projection of the second camera portion 250 relative to the electron optical column portion 200 can be made small. Because the horizontal drive mechanism 262 is adopted, the other detecting device 260 jutting a long way outward can be disposed in a left-and-right direction. Consequently, if the other detecting device 260 is mounted to be exposed from above the table surface 110, its effects can be alleviated. Thus, the workability and design on the table surface 110 can be improved.

Additionally, in this embodiment, a structure in which the outside of the other detecting device 260 is covered by a detector cover 270 is adopted. This detector cover 270 is made of a plate formed from a metal material such as Permalloy, steel, or aluminum. The cover is detachably mounted to the observation chamber 230. This detector cover 270 shields the other detecting device 260 against heat, air flow, electromagnetic waves, dust, and so on received from the outside. Hence, it is easy to obtain high resolution.

Furthermore, another great feature of the electron microscope body 20 associated with this embodiment is that the second fluorescent screen 241 of the second imaging device 240 is fixed in a tilted posture and mounted such that the fixed fluorescent screen 241 can be retracted with the horizontal drive device 242.

That is, in the conventional structure, a structure in which the second fluorescent screen 241 constituting the second imaging device 240 and a mirror are mounted rotatably within the observation chamber 230 is adopted and so the range of operation occupied by the second imaging device 240 within the observation chamber 230 has been large. For this reason, there has been the problem that it is difficult to mount the other detecting device 260 near the second imaging device 240.

In this embodiment, a structure in which the second fluorescent screen 241 is fixed at a preset angle and a retracting operation is performed while maintaining the fixed angle is adopted. In consequence, the range of operation of the second imaging device 240 occupied within the observation chamber 230 can be reduced. Furthermore, the range of operation (heightwise direction) occupied within the observation chamber 230 can be reduced by setting the tilt angle of the second fluorescent screen 241 to an upward direction from the direction of 45 degrees and mounting the second camera portion 250 in an oblique posture according to the upward angle. Furthermore, the amount of jut forwardly of the second camera portion 250 can be reduced by mounting the second camera portion 250 at an angle.

The electron microscope system 1 associated with this embodiment is described further below with reference to FIG. 1 and FIGS. 2-4. Since the transmission electron microscope adopted by this embodiment has a well-known structure, the structure is described merely roughly.

First, the structure of the transmission electron microscope 20 associated with this embodiment is schematically shown in FIG. 2. The electron gun 210 disposed at the top of an electron optical column portion 200 emits an electron beam which is directed at the sample 221 set in the sample portion 220 mounted in the middle stage of the electron optical column portion 200 via a condenser lens 215 constituting an illumination system. Because of the illumination, the electron beam transmitted through the sample 221 reaches the first fluorescent screen 290 via an objective lens 225, an intermediate lens 226, and a projector lens 227 which together constitute an imaging system. An image of the sample 221 is focused onto the fluorescent screen portion 290 based on the transmitted electron beam. The focused image is a transmission image or a diffraction image depending on set observation conditions.

An objective aperture means 228 is mounted below the objective lens 225 such that the aperture means can be inserted into and out of the beam axis P of the transmitted electron beam. The objective aperture means 228 is provided with an opening 229. When the objective aperture means 228 lies on the beam axis P of the transmitted electron beam, a part of the transmitted electron beam passes through the opening 229. A focused image is created on the first fluorescent screen portion 290 based on the transmitted electron beam passed through the opening 229.

The image focused on the first fluorescent screen portion 290 in this way is picked up by the first camera portion 291. The first camera portion 291 is equipped with imaging elements such as CCDs. The image is picked up by the imaging elements. Image data about the image picked up by the first camera portion 291 is sent to the monitor device 50. The control unit 54 image-processes the image data and displays the image on a display portion 52.

In this embodiment, the observation chamber 230 is provided from the projector lens 227 to the first fluorescent screen portion 290. In the observation chamber 230, a thin electron beam emitted from the projector lens 227 is directed radially toward the first fluorescent screen portion 290 and focused as an image of a given size onto the first fluorescent screen portion 290.

In this embodiment, the second imaging device 240 capable of directly observing the image which has been refracted after being radially emitted is provided in this observation chamber 230. Other plural detecting devices 260 and the electron beam stopper 263 can also be detachably mounted.

The second imaging device 240 is configured including the second fluorescent screen 241 fixed at a tilt angle θ1, the horizontal drive device 242 mounted to a wall surface on the rear side of the observation chamber 230, and the second camera portion 250 mounted to a wall surface on the front side of the observation chamber 230. The horizontal drive device 242 can rearwardly retract the second fluorescent screen 241 on the beam axis P of the electron beam and move the retracted second fluorescent screen 241 onto the beam axis P.

The second fluorescent screen 241 is mounted to the front end of the horizontal drive device 242 while assuming a posture where the rear side is raised at the tilt angle θ1 from the horizontal position. The conventional second fluorescent screen 241 is mounted in a posture tilted at 45 degrees, and has a structure that bends the vertical beam axis P through 90 degrees. However, if one attempts to retract the second fluorescent screen 241 in a posture tilted at 45 degrees via the horizontal drive device 242, the height of a region of operation Q1 having a height of h1 is needed.

Accordingly, in this embodiment, the height h1 of the range of operation Q1 is reduced by setting the tilt angle θ1 of the second fluorescent screen 241 to less than 45 degrees. As a result, the range of operation Q1 occupying the height H of the observation chamber 230 exposed on the table surface 110 of the pedestal housing 100 is reduced. The space in which the other detecting device 260 is installed can be secured in other range more easily.

On the other hand, there is the problem that the image will be distorted unless the optical axis P2 of the second camera portion 250 for picking up the image of the second fluorescent screen 241 is set at right angles to the second fluorescent screen 241. Accordingly, in a conventional example, the second camera portion 250 is mounted in the observation chamber 230 such that the optical axis P2 of the second camera portion 250 assumes a horizontal posture. However, there is the problem that the horizontally mounted second camera portion 250 juts a long way in a horizontal direction. In view of this problem, with respect to the second camera portion 250 of this embodiment, the second fluorescent screen 241 is installed at an angle close to a horizontal direction. Therefore, it is mounted in a tilted posture in the observation chamber 230. Hence, the above-described problem can be alleviated.

Besides, the control unit 54 controls the electron gun 210, controls the illumination system having the condenser lens 215 disposed in the electron optical column portion 200, and controls the imaging system having the objective lens 225, the intermediate lens 226, and the projector lens 227. The control unit 54 can control the objective aperture means 228 for moving the objective aperture, the first camera portion 291, the second imaging device 240, the other detecting device 260, the electron beam stopper 263, and so on. These control operations can be performed by giving instructions on the operations via the input devices 53 while manipulating a monitor image displayed on the display portion 52.

The observation chamber 230 that is a characteristic structure of this embodiment is next described further. The structure of the observation chamber 230 shown in this FIG. 3 shows a transverse cross section as viewed from the front side of the electron optical column portion 200. In this FIG. 3, the second fluorescent screen 241 mounted to the horizontal drive device 242 behind the observation chamber 230 exposed on the table surface 110 is mounted, and the second camera portion 250 (not shown) is mounted ahead of it.

In this embodiment, two detector mounting portions 231 (231a, 231b, 231c, and 231d) are formed up and down on each of the both sides of the observation chamber 230 exposed on the table surface 110. In this embodiment, a detecting device 260a for a dark field image is mounted to the detector mounting portion 231a in the left upper stage of the observation chamber 230. A detecting device 260b for a bright field image is mounted to the detector mounting portion 231b in the left lower stage of the observation chamber 230. The electron beam stopper 263 is mounted to the detector mounting portion 231c in the right upper stage of the observation chamber 230. The detector mounting portion 231d in the right lower stage of the observation chamber 203 is a preliminary installation space. Furthermore, in this embodiment, detector mounting portions 231 (231e and 231f) are mounted on both sides of the observation chamber 230 concealed below the table surface 110. In the embodiment of this FIG. 3, a state in which the other detecting device 260 is mounted to the left detector mounting portion 231e is shown.

As is obvious from FIG. 3, this embodiment divides the observation chamber 230 exposed on the table surface 110 into two (up and down) stages and exploits them. The second imaging device 240, the other detecting device 260, and the electron beam stopper 263 can be mounted so as to be retractable relative to the electron beam by utilizing the range of operation Q1 in the lower stage and the range of operation Q2 in the upper stage.

For instance, one range of operation Q2 can be used for two devices by arranging the detector mounting portion 231a and the electron beam stopper 263 on the opposite sides of the beam axis P of the electron beam in the range of operation Q2 in the upper stage, i.e., in a mutually opposite relation to each other.

The second imaging device 240 and the other two detecting devices 260 can be mounted in the range of operation Q1 in the lower stage. That is, the second camera portion 250 and the second fluorescent screen 241 mounted to the horizontal drive device 242 are mounted ahead of and behind the range of operation Q1. The other two detecting devices 260 can be mounted on the left and right sides of the range of operation Q1. Therefore, the lower-stage range of operation Q1 of this embodiment can be used as a range of operation for devices mounted in three directions spaced from each other by 90 degrees (second fluorescent screen 241 and the other two detectors 261).

In this embodiment, a portion ahead of the upper stage and a portion ahead of the lower stage can be used as the installation space for the second camera portion 250 in a tilted posture by mounting the second imaging device 240 in the lower stage.

The detector cover 270 associated with this embodiment is next described by referring to FIG. 4. In FIG. 4, (a) indicates a plan view of the detector cover, (b) indicates a front elevation, (c) indicates a left side elevation, and (d) indicates a right side elevation.

In FIG. 4, the embodiment of the detector cover 270 shown in this FIG. 4 has a structure for shielding each of the other detecting devices 260 in isolation. That is, the detector cover 270 has a mounting portion 272 equipped with an opening portion 271 on its right side surface. The cover is covered with a metal material except for the opening portion 271. Its outer appearance is rounded to have a nonangular shape such that the cover is contrived in such a manner that the size is not felt from the front.

When this detector cover 270 is mounted, only the other detecting devices 260 are first mounted to the detector mounting portions 231 and then the detector cover 270 is mounted via the opening portion 271 so as to cover the other detecting devices 260. The mounting portions 272 are attached to the detector mounting portions 231 via screws (not shown).

In this way, according to this embodiment, as shown in FIG. 1, the other detecting devices 260 covered by the detector cover 270 are mounted on both sides of the observation chamber 230 exposed over the table surface 110. Therefore, if the other detecting devices 260 jut a long way, then hindrance to the workability on the table surface 110 is reduced. Furthermore, the other detecting devices 260 covered with the detector cover 270 are mounted so as to be exposed over the table surface 110. Consequently, the workability in attaching and detaching these devices and serving them is improved greatly.

### Embodiment 2

FIGS. 5 and 6 show other embodiment of the detector cover. In each of these figures, (a) indicates an illustrated parts breakdown in the vicinities of the observation chamber and (b) shows an outer appearance near the observation chamber.

In the electron microscope system 1 associated with this invention, the other plural detecting devices 260 can be mounted in the observation chamber 230 in which the second imaging device 240 is mounted. However, it is necessary to shield the other detecting devices 260 against heat, air flow, electromagnetic waves, dust, and so on received from the outside. Where there is only a single detecting device 260, mounting the detector cover 270 shown in FIG. 4 is effective. Where the other detecting devices 260 are plural, time and labor to mount and service them will pose the problems.

Accordingly, the embodiment of FIGS. 5 and 6 adopts a structure in which the other plural detecting devices 260 can be efficiently covered and shielded.

First, in FIG. 5, a single shield cover 300 associated with this embodiment covers the other up and down detecting devices 260 while taking notice of the fact that the other detecting devices 260, two at maximum, are mounted on both sides of the observation chamber 230 in an up and down relation.

In this embodiment, the shield cover 300 on which the other detecting devices 260 mounted in an up and down relation can be mounted in a batch is mounted symmetrically left and right on both sides of a camera cover 301 of the second camera portion 250 that is mounted to the front portion of the observation chamber 230.

The shield cover 300 that covers the other plural detecting devices 260 is provided with an open portion 302 extending across one side surface and a bottom surface mounted to the detector mounting portions 231 to facilitate attachment. Concomitantly, the table surface 110a of the pedestal housing 100 is composed of a front table surface 111 and a pair of side table surfaces 112 separated apart on both sides. The side table surfaces 112 are provided with cutout portions 113 continuous with the open portion 302 in the bottom surface of the shield cover 300.

According to the embodiment shown in this FIG. 5, the cutout portions 113 provide sufficiently large working spaces on both sides of the observation chamber 230 and so the other detecting devices 260 can be easily mounted to the detector mounting portions 231. Furthermore, after mounting the other detecting devices 260 to the detector mounting portions 231, shielding can be provided simply by mounting the shield cover 300 to the mounting portions.

With respect to the shield cover 310 shown in FIG. 6, the camera cover 301 providing a cover over the second camera portion 250 and the shield cover 300 providing a cover over the other detecting devices 260 are integrally formed while taking notice of the fact that the detector mounting portions 231 are present on both sides of the second camera portion 250.

This shield cover 310 is provided with an opening portion 311 extending continuously across both the portion touching the observation chamber 230 and the bottom surface. On the other hand, a table surface 110b is composed of the front table surface 111 and a rear table surface 114. The rear table surface 114 is formed to surround the front and both sides of the electron optical column portion 200. The front portion is provided with a cutout portion 115 that leaves open both sides of the observation chamber 230.

According to this embodiment, both sides of the observation chamber 230 are left open to a great extent by the cutout portion 115. This can greatly improve the workability in attaching and detaching and servicing the other detecting devices 260. Besides, after the other detecting devices 260 are mounted, the second camera portion 250 and the other detecting devices 260 on both sides of the observation chamber 230 can be covered in a batch simply by mounting the detector cover 270. Hence, the workability can be improved greatly.

### REFERENCE SIGNS LIST

1: electron microscope system; 20: electron microscope body; 40: peripheral device housing; 50: monitor device; 51: table housing; 52: display portion; 53: input devices; 54: control unit; 100: pedestal housing; 110, 110a, 110b: table surfaces; 111: front table surface; 112: side table surface; 113: cutout portion; 114: rear table surface; 115: cutout portion; 200: electron optical column portion; 210: electron gun; 215: condenser lens; 220: sample insertion portion; 221: sample; 225: objective lens; 226: intermediate lens; 227: projector lens; 228: objective aperture means; 230: observation chamber; 231: detector mounting portion; 240: second imaging device; 241: second fluorescent screen; 242: horizontal drive device; 250: second camera portion; 260: other detecting devices; 260a: detecting device; 231b: detector mounting portion; 261: other detector(s); 262: horizontal drive device; 263: electron beam stopper; 270: detector cover; 271: opening portion; 272: mounting portion; 300: shield cover; 301: camera cover; 302: open portion; 290: first fluorescent screen portion; 291: first camera portion; P: beam axis; P2: optical axis; θ1: tilt angle; H: height of observation chamber exposed over table surface; h1: height; Q1, Q2: ranges of operation.

## Claims

1. An electron microscope, comprising:
a first imaging device for irradiating a sample with an electron beam within an electron optical column portion, projecting the transmitted beam onto a first fluorescent screen mounted in a lower end portion of the electron optical column portion, and picking up an image of the projected subject; and
a second imaging device mounted in an observation chamber formed over the first fluorescent screen,
wherein the second imaging device is mounted so as to be retractable relative to the transmitted beam; and
wherein mounting portions for other detecting devices are mounted at positions in flush with a position at which the second imaging device is mounted.

2. The electron microscope according to claim 1, wherein the second imaging device is configured including a second camera portion mounted to a front wall surface of the observation chamber and a second fluorescent screen mounted via a horizontal drive device mounted to a rear-side wall surface of the observation chamber so as to be retractable relative to the transmitted beam, and wherein the mounting portions for the other detecting devices are formed on at least one side wall of the observation chamber.

3. The electron microscope according to claim 2, wherein the mounting portions for the other detecting devices are mounted at the same height as the horizontal drive device of the second imaging device.

4. The electron microscope set forth in claim 3, wherein the second fluorescent screen is fixed at an angle smaller than 45 degrees to the horizontal, and wherein the second camera portion has its optical axis mounted in a posture perpendicular to a surface of the second fluorescent screen.

5. The electron microscope according to claim 4, wherein the mounting portions for the other detecting devices are mounted in two stages spaced up and down from each other to a side wall of the observation chamber, and wherein the second imaging device is mounted at a position corresponding to the lower stage.

6. The electron microscope according to claim 1, wherein there is further provided an image processing portion for forming an image based on signals from the other detecting devices.

7. The electron microscope according to claim 1, wherein each of the other detecting devices is a dark field detector or a bright field detector.

8. The electron microscope according to claim 1, wherein the other detecting devices are detachably mounted to the mounting portions.

9. An electron microscope, comprising:
a first imaging device for irradiating a sample with an electron beam within an electron optical column portion, projecting the transmitted beam onto a first fluorescent screen mounted in a lower end portion of the electron optical column portion, and picking up an image of the projected subject; and
a second imaging device mounted in an observation chamber formed over the first fluorescent screen,
wherein the second imaging device is mounted so as to be retractable relative to the transmitted beam; and
wherein mounting portions for other detecting devices are mounted at positions angularly spaced by 90 degrees in a horizontal direction from a position at which the second imaging device is mounted.

10. An electron microscope, comprising:
an illumination optical system for irradiating a sample with an electron beam;
a first fluorescent screen onto which the electron beam transmitted through the sample is projected; and
an imaging device mounted in an observation chamber formed over the first fluorescent screen,
wherein the imaging device is mounted so as to be retractable relative to the optical axis of the electron beam transmitted through the sample; and
wherein there are further provided detachable detecting devices in positions in flush with the imaging device.
